# EUROPÄISCHE PATENTSCHRIFT

(11) **EP 2 845 225 B1**
(45) Veröffentlichungstag und Bekanntmachung des Hinweises auf die Patenterteilung: **27.06.2018**
(21) Anmeldenummer: 13715889.5
(22) Anmeldetag: 21.03.2013
(51) Int. Cl.: H01L 25/075, B41J 2/45, H01L 33/58, B41F 23/04, G02B 3/06

(54) **LEUCHTE MIT LEDS UND ZYLINDERLINSE**
LUMINAIRE WITH LEDS AND CYLINDRICAL LENS
DISPOSITIF D'ÉCLAIRAGE À DEL ET À LENTILLE CYLINDRIQUE

(30) Priorität: 02.05.2012 DE 102012008638
(43) Veröffentlichungstag der Anmeldung: 11.03.2015
(73) Patentinhaber: Heraeus Noblelight GmbH, 63450 Hanau (DE)
(72) Erfinder: PEIL, Michael, 64853 Otzberg (DE); SCHADT, Susanne, 63505 Langenselbold (DE); MAIWEG, Harald, 41352 Korschenbroich (DE)
(74) Vertreter: Herzog, Fiesser & Partner Patentanwälte PartG mbB
(86) Internationale Anmeldenummer: PCT/EP2013/000861
(87) Internationale Veröffentlichungsnummer: WO 2013/164053

(56) Entgegenhaltungen:
- EP-A1- 0 625 846
- EP-A1- 1 403 077
- US-A1- 2011 198 619

## Beschreibung

Die Erfindung betrifft eine Leuchte, umfassend zumindest ein Modul mit einer Mehrzahl von über eine Modulfläche verteilten LEDs, wobei in einer Längsrichtung des Moduls mehrere LEDs in einer Reihe angeordnet sind, und wobei in einer zu der Längsrichtung senkrechten Querrichtung des Moduls mehrere der Reihen nebeneinander angeordnet sind, und wobei die LED-Leuchte eine Optik zur Bündelung des von den LEDs emittierten Lichts umfasst.

WO 2012/031703 A1 beschreibt ein Herstellungsverfahren für Chip-On-Board-Module, bei denen ein Substrat einen plattenförmigen Träger mit mehreren LEDs umfasst, wobei eine Oberfläche des Substrats in einer offenen Gießform überdeckend mit einer Schicht zur Ausbildung einer Optik versehen wird. EP 1 403 077 A1 beschreibt eine Vorrichtung zum zeilenförmigen Beleuchten mit einer auf Zylinderlinsen basierten Primäroptik und einer Sekundäroptik. Es ist die Aufgabe der Erfindung, eine LED-Leuchte anzugeben, mit der eine homogene Bestrahlungsdichte in einer definierten Struktur erzielbar ist.

Diese Aufgabe wird gelöst durch eine Leuchte gemäß Anspruch 1, umfassend zumindest ein Modul mit einer Mehrzahl von über eine Modulfläche verteilten LEDs,
wobei in einer Längsrichtung des Moduls mehrere LEDs in einer Reihe angeordnet sind, und
wobei in einer zu der Längsrichtung senkrechten Querrichtung des Moduls mehrere der Reihen nebeneinander angeordnet sind,
und wobei die LED-Leuchte eine Optik zur Bündelung des von den LEDs emittierten Lichts umfasst,
wobei die Optik zumindest eine erste, in der Längsrichtung erstreckte Zylinderlinse umfasst,
wobei das Licht zumindest einiger der LEDs einer ersten der Reihen mittels der ersten Zylinderlinse in eine Linie auf einer Zielfläche gebündelt wird.

Durch die Verwendung einer über zumindest mehrere LEDs durchgehend erstreckte Zylinderlinse lässt sich effektiv und mit wenigen Bauteilen eine homogene Bündelung des Lichtes der einzelnen LEDs erzielen.

Unter einem Modul im Sinne der Erfindung ist jede raumfeste Anordnung der Mehrzahl von LEDs zu verstehen. Die Modulfläche ist dabei als eine sämtliche LEDs verbindende Fläche zu verstehen. Die Modulfläche kann im Sinne der Erfindung auch eine Wölbung aufweisen, zum Beispiel eine tonnenartige Wölbung in der Querrichtung. Bevorzugt ist die Modulfläche aber eben.

Das Modul ist allgemein vorteilhaft, aber nicht notwendig als integriertes Chip-On-Board-Modul (COB) ausgebildet, bei dem die LEDs und gegebenenfalls weitere Elektronikbauteile auf einem flächigen Träger angeordnet sind.

Ganz allgemein kann die erfindungsgemäße Leuchte insbesondere in der Längsrichtung beliebig erstreckt sein. Eine Erstreckung in der Querrichtung hängt vorrangig von den Anforderungen an Anzahl, Leistung und Intensität der Linien auf der Zielfläche ab. Bezüglich der Erstreckung in der Längsrichtung können je nach geforderter Länge mehrere Module unmittelbar hintereinander angeordnet werden, was analog auch für gegebenenfalls verwendete Optiken gilt.

Bei einer allgemein vorteilhaften Weiterbildung der Erfindung umfasst die Optik zumindest eine zweite, in der Längsrichtung erstreckte Zylinderlinse, wobei das Licht zumindest einiger der LEDs einer zweiten der Reihen mittels der zweiten Zylinderlinse in eine Linie auf einer Zielfläche gebündelt werden. Auf diese Weise können mehrere Reihen von LEDs des Moduls in Linien gebündelt werden, wobei jeweils ein großer Öffnungswinkel des Lichts auch in der Querrichtung erfasst und transportiert werden kann.

In bevorzugter, aber nicht notwendiger Detailgestaltung bündeln dabei die erste Zylinderlinse und die zweite Zylinderlinse das Licht in dieselbe Linie auf der Zielfläche. Dies sorgt für eine besonders große Helligkeit in der Zielfläche. Die Homogenität der Lichtintensität entlang der Linie kann dabei auf einfache Weise weiter verbessert werden, etwa indem die LEDs der beiden Reihen in der Längsrichtung versetzt zueinander angeordnet sind. Alternativ oder ergänzend dazu kann eine weitere Optimierung der Homogenität auch durch Maßnahmen seitens der bündelnden Optik erfolgen. Erfindungsgemäß umfasst die Optik eine Primäroptik zur Bündelung des abgestrahlten Lichts, wobei die Primäroptik eine Mehrzahl von unmittelbar auf den LEDs angeordneten Linsen umfasst. Durch eine solche Primäroptik lässt sich ein besonders großer Raumwinkel des von den LEDs meist großwinkelig abgestrahlten Lichtes transportieren. Zum Beispiel kann es sich dabei um mehrere, jeweils über einer LED angeordnete Sammellinsen handeln. Grundsätzlich kann auch die Zylinderlinse Bestandteil der Primäroptik sein und unmittelbar über einer Mehrzahl der LEDs angeordnet sein.

Alternativ oder ergänzend zu einer Sammellinse oder Zylinderlinse kann die Primäroptik auch Reflektoren umfassen, die unmittelbar seitlich der LEDs angeordnet sind und einen nutzbaren Raumwinkelbereich des transportierten Lichts weiter verbessern. Es kann sich zum Beispiel um rotationssymmetrische, jeweils einzelnen LEDs zugeordnete Reflektoren.

Bei einer bevorzugten Weiterbildung ist die Primäroptik als auf die Module aufgebrachte, transparente Polymerschicht ausgebildet ist, die zumindest mehrere LEDs einstückig übergreift. Eine solche Polymerschicht kann zum Beispiel nach Art der in WO 2012/031703 A1 beschriebenen Optiken ausgebildet sein. Dabei wird ein LED-Modul mittels einer offenen Gießform mit einem UV-beständigen Silikon überzogen.

Bei einer bevorzugten Weiterbildung einer Primäroptik sind die über den LEDs angeordneten Linsen mit einem seitlichen Versatz in der Querrichtung gegenüber einem Zentrum der LEDs positioniert. Dies ermöglicht eine gute Bündelung eines großen Öffnungwinkels in der Querrichtung, wenn die Linie der Zielfläche sich nicht in der geometrischen Abstrahlrichtung der LEDs der Reihe befindet. So kann in bevorzugter Weiterbildung zum Beispiel der Versatz umso größer sein, je weiter die LED-Reihe in der Querrichtung von der Linie entfernt ist. Insbesondere kann eine zentrale LED-Reihe vorliegen, deren geometrische Abstrahlrichtung die Linie schneidet, wobei die Linse oder Linsen dieser Reihe keinen Versatz aufweisen.

Vorteilhaft liegen wenigstens 50% des von den LEDs emittierten Lichtes in einem Wellenlängenbereich von weniger als 470nm vor. Dies ermöglicht eine zumindest überwiegende Auslegung der Leuchte als UV-Strahler. Durch die weitere Kombination der erfindungsgemäßen Merkmale kann der UV-Strahler flexibel in einer technischen Vorrichtung, zum Beispiel einer Druckmaschine, eingebaut werden.

Alternativ hierzu liegen wenigstens 50% des von den LEDs emittierten Lichtes in einem Wellenlängenbereich von mehr als 780nm vor. Dies ermöglicht eine zumindest überwiegende Auslegung der Leuchte als IR-Strahler. Durch die weitere Kombination der erfindungsgemäßen Merkmale kann der IR-Strahler flexibel in einer technischen Vorrichtung, zum Beispiel einer Druckmaschine, eingebaut werden. Gemäß der Erfindung umfasst die Optik eine Sekundäroptik, die räumlich getrennt von dem Modul in einem Strahlengang des Lichts angeordnet ist. In Abgrenzung zum Begriff einer Primäroptik wird unter einer Sekundäroptik vorliegend allgemein eine Optik verstanden, die nicht unmittelbar auf den LEDs aufsitzt. Es sind daher nicht zur Erfindung gehörende Beispiele möglich, die eine Sekundäroptik, aber keine Primäroptik umfassen, sowie umgekehrt. Erfindungsgemäß sind sowohl eine Primäroptik als auch eine Sekundäroptik in dem Strahlengang der Leuchte angeordnet, wodurch eine besonders kleine Bauform bei hoher und homogener Beleuchtungsstärke resultiert.

In bevorzugter Detailgestaltung ist die Sekundäroptik als transparente Polymerschicht auf einem transparenten Substrat ausgebildet. Die Sekundäroptik kann dabei nach Art der in WO 2012/031703 A1 beschriebenen Optiken hergestellt sein, wobei an Stelle eines LED-Moduls ein transparentes Substrat, zum Beispiel Glass, mittels einer offenen Gießform mit einem UV-beständigen Silikon überzogen wird.

In der erfindungsgemäßen Ausführung ist die Zylinderlinse an der Sekundäroptik ausgebildet, wodurch eine homogene Bündelung des von den LEDs abgestrahlten Lichts in die Linie besonders effektiv erfolgt. Bevorzugt kann dabei die Sekundäroptik mehrere in einer Ebene nebeneinander angeordnete Zylinderlinsen umfassen. Somit kann eine Zylinderlinse jeweils das Licht einer der Reihen der LEDs oder auch mehrerer nebeneinander liegender Reihen bündeln, so dass insgesamt eine große Anzahl von LED-Reihen zur der Gesamtintensität der Leuchte beitragen können. Insbesondere können die verschiedenen Zylinderlinsen das Licht der LEDs jeweils in dieselbe Linie bündeln.

Bei einer möglichen Ausführungsform der Erfindung ist die Ebene der Zylinderlinsen relativ zu der Modulfläche und/oder zu der Zielfläche geneigt. Hierdurch lässt sich auf einfache Weise ein Versatz zwischen der Linie und einer Position des Moduls in der Querrichtung kompensieren. So können zum Beispiel in der Querrichtung auf jeder Seite der Linie Module vorgesehen sein, die in jeweils entgegen gesetzter Kipprichtung gegenüber einer Sekundäroptik angestellt sind und somit eine besonders effektive Bündelung in die Linie erlauben. Auch eine geneigte Anordnung der Sekundäroptik oder auch des Moduls und der Sekundäroptik gegenüber der Zielfläche sind möglich.

Bei einer weiteren Ausführungsform der Erfindung ist es vorgesehen, dass eine Mittelebene der Reihe von LEDs und eine hierzu parallele optische Zentralebene einer das Licht der Reihe bündelnden Zylinderlinse einen Versatz in der Querrichtung zueinander aufweisen. Auch hierdurch ist eine einfache und effektive Bündelung eines großen Öffnungswinkels in die Linie erzielbar, insbesondere wenn die Linie in Querrichtung versetzt gegenüber der Mittelebene der LEDs angeordnet ist. In weiterer Optimierung kann ein solcher Versatz zu einer zugeordneten Zylinderlinse für verschiedene Reihen der LEDs verschieden groß sein, je nachdem, welchen Abstand die Linie von der LED-Reihe in der Querrichtung hat.

Allgemein vorteilhaft ist es vorgesehen, dass eine Packungsdichte der LEDs in der Längsrichtung größer ist als in der Querrichtung. Die geringere Packungsdichte in der Querrichtung kann durch eine optimierte, erfindungsgemäße Transportoptik ausgeglichen werden, so dass insgesamt mit weniger LEDs dieselbe Intensität auf der Zielfläche erreicht werden kann. Zum Beispiel kann das Modul ein COB-Modul sein, bei dem die Packungsdichte in der Längsrichtung maximal ist. Dies wird regelmäßig durch die technischen Bestückungsmöglichkeiten solcher Module limitiert. Eine in Längsrichtung maximale Packungsdichte ist zugleich optimal für die Homogenität der Intensitätsverteilung auf der Linie. Die Packungsdichte in der Querrichtung kann zum Beispiel nur 80%, bevorzugt nicht mehr als 60% einer Packungsdichte in der Längsrichtung aufweisen.

Die Aufgabe der Erfindung wird zudem durch eine Vorrichtung zum Trocknen einer Beschichtung gelöst, umfassend eine erfindungsgemäße Leuchte. Die erfindungsgemäße Leuchte ist hierzu besonders gut geeignet, da sie hohe Bestrahlungsstärken mit flexibler und insbesondere kompakter Bauform kombiniert.

In bevorzugter Weiterbildung sind dabei ein flächiges Substrat mit der zu trocknenden Beschichtung und die Leuchte in einer Förderrichtung zueinander bewegbar, wobei die Leuchte in einer Querrichtung zumindest teilweise über eine Breite des Substrats erstreckt und in definiertem Abstand über dem Substrat angeordnet ist. Hierunter ist auch auch ein rasterndes Abfahren der Substratfläche in mehreren Bahnen zu verstehen. Zum Beispiel kann es sich bei dem Substrat um ein Druckerzeugnis handeln, das in einer Druckmaschine mit aufgedrucktem Lack oder einer anderen Substanz beschichtet wird.

Die Aufgabe der Erfindung wird zudem durch die Verwendung einer erfindungsgemäßen Leuchte zum Trocknen einer Beschichtung gelöst, bevorzugt in einem Druckverfahren.

Weitere Vorteile und Merkmale der Erfindung ergeben sich aus dem nachfolgend beschriebenen Ausführungsbeispiel sowie aus den abhängigen Ansprüchen.

Nachfolgend werden mehrere bevorzugte Ausführungsbeispiele der Erfindung beschrieben und anhand der anliegenden Zeichnungen näher erläutert.
- Fig. 1: zeigt eine schematische Darstellung eines ersten Ausführungsbeispiels einer erfindungsgemäßen Leuchte.
- Fig. 2: zeigt eine schematische Anordnung von LEDs aus einem LED-Modul der Leuchte gemäß Fig. 1.
- Fig. 3: zeigt eine Schnittansicht der Leuchte aus Fig. 1 in einer Längsrichtung.
- Fig. 4: zeigt eine Abwandlung der Leuchte aus Fig. 1.
- Fig. 5: zeigt eine Darstellung eines zweiten Ausführungsbeispiels der Erfindung.
- Fig. 6: zeigt eine Darstellung eines dritten Ausführungsbeispiels der Erfindung.
- Fig. 7: zeigt eine Darstellung eines vierten Ausführungsbeispiels der Erfindung.

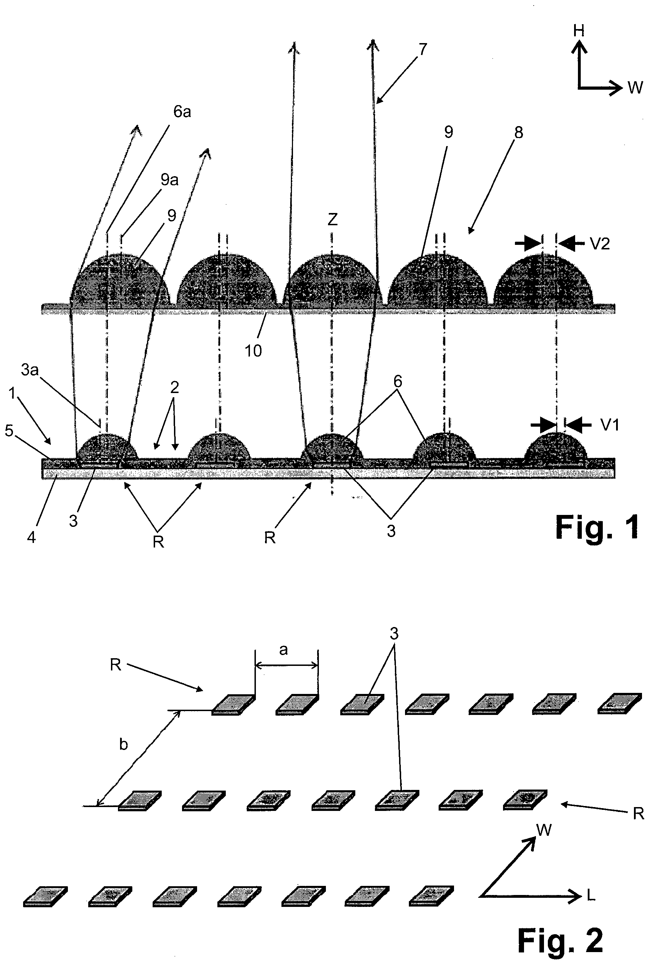

Eine erfindungsgemäße Leuchte gemäß Fig. 1 umfasst ein LED-Modul 1 mit jeweils mehrere LEDs 3, die in einem Raster über eine senkrecht zur Zeichnungsebene verlaufende Modulfläche 2 verteilt sind. Die LEDs 3 sind zusammen mit weiteren elektronischen Komponenten (nicht dargestellt) auf einem ebenen Träger 4 aufgebracht, wodurch insgesamt ein Chip-On-Board-Modul (COB) ausgebildet ist. Das Modul 1 erstreckt sich in einer in Fig. 1 senkrecht zur Zeichnungsebene verlaufenden Längsrichtung L und in einer Querrichtung W, die in der Zeichnung Fig. 1 von links nach rechts verläuft. Eine geometrische Hauptabstrahlrichtung H der LEDs 3 verläuft senkrecht zu der Längsrichtung L und der Querrichtung W.

Die im Raster angeordneten LEDs 3 verlaufen in Reihen R in der Längsrichtung, in denen sie einen ersten Wiederholabstand a haben. In der Querrichtung sind die Reihen R parallel zueinander und haben einen Wiederholabstand b. Vorliegend sind etwa zehn Reihen R von LEDs nebeneinander angeordnet, die in den Zeichnungen nicht sämtlich dargestellt sind.

Durch die Kehrwerte der Wiederholabstände a, b sind Packungsdichten der LEDs in den jeweiligen Richtungen definiert. Vorliegend beträgt der Abstand a je nach Detailgestaltung 2 mm bis 5 mm, wobei die LEDs eine abstrahlende Fläche in der Größenordnung von etwa 1 mm² haben. Der Abstand b beträgt typisch zwischen 5 mm und 10 mm und ist rund doppelt so groß wie der Abstand a. Demnach ist die Packungsdichte in der Querrichtung W nur etwa halb so groß wie in der Längsrichtung L.

Insbesondere in der Längsrichtung, bei Bedarf aber auch in der Querrichtung, können jeweils mehrere Module 1 hintereinander angeordnet sein, je nach Anforderungen der Baugröße der Leuchte. Zweckmäßig sind die aufeinander folgenden Module dabei so mit LEDs 3 bestückt bzw. hintereinander angeordnet, dass die Abstände der LEDs gleich sind bzw. möglichst keine Veränderung in der Verteilung des abgestrahlten Lichts im Bereich der Modulgrenzen besteht.

Auf den Modulen 1 ist eine Primäroptik 5 angeordnet, die vorliegend als vollflächige Beschichtung der Module 1 ausgebildet ist. Die Primäroptik 5 weist unmittelbar auf den einzelnen LEDs 3 jeweils Linsen 6, vorliegend plankonvexe Sammellinsen, auf, mittels derer ein großer Öffnungswinkel des abgestrahlten Lichts gebündelt wird. Dabei erfolgt eine überwiegende Bündelung der Strahlen in eine Struktur in Form einer geraden, in der Längsrichtung verlaufenden Linie in einer Zielfläche (nicht dargestellt). Auf dieser Linie beträgt die Bestrahlungsstärke durch die Leuchte vorliegend deutlich mehr als 2 W/cm².

Zur Veranschaulichung sind in Fig. 1 zwei randseitig extremale Strahlengänge 7 eingezeichnet, die konvergieren und sich weiter oberhalb auf der nicht dargestellten Linie bzw. Zielfläche treffen.

Die Module 1 können auf Kühlkörpern (nicht dargestellt) angeordnet sein. Die Kühlkörper haben bevorzugt Anschlüsse für Eintritt und Austritt eines flüssigen Kühlmittels, das die Kühlkörper zum Abtransport der Wärme durchströmt. Das Kühlmittel kann in einem geschlossenen Kreislauf vorliegen und die Wärme an anderer Stelle über einen Wärmetauscher wieder abgeben. Bei der vorliegenden Leuchte treten abzuführende Wärmeleistungen im Bereich von wesentlich mehr als 1 kW auf.

Zusätzlich zu der Primäroptik 1 ist eine Sekundäroptik 8 vor den Modulen 1 vorgesehen, wodurch die Bündelung eines möglichst großen Austrittswinkels aus den LEDs in die Struktur auf der Zielfläche weiter verbessert wird. Die Sekundäroptik 8 ist beabstandet vor dem Modul 1, aber zwischen dem Modul 1 und der Zielfläche angeordnet. Der Abstand zwischen Sekundäroptik 8 und der Modulfläche 2 ist wesentlich kleiner als der Abstand der Sekundäroptik 8 von der Zielfläche, um möglichst früh bündelnd auf den Strahlengang einzuwirken.

Die Sekundäroptik 8 umfasst jeweils mehrere parallele Zylinderlinsen 9, die in der Längsrichtung L erstreckt und in der Querrichtung W parallel zueinander und in einer Ebene angeordnet sind. Somit wird das Licht zumindest jeweils einer Reihe von LEDs 3 von einer der Zylinderlinsen 12 erfasst und in die Linie bzw. Struktur der Zielfläche 10 (Druckerzeugnis) gebündelt. Exemplarisch sind in Fig. 1 verschiedene Lichtstrahlen von zwei LEDs unter jeweils unterschiedlichem Abstrahlwinkel eingezeichnet, die sämtlich in dieselbe linienförmige Struktur in der Zielfläche gebündelt werden. Die Linie hat dabei eine Breite in der Querrichtung Q, die erheblich kleiner ist als der Abstand der äußeren Reihen R von LEDs 3 in der Querrichtung. In einem vereinfachten, nicht zur beanspruchten Erfindung gehörenden Beispiel, kann auf die Sekundäroptik verzichtet werden, wobei die Zylinderlinsen unmittelbar in der Primäroptik ausgebildet sind und sich über die einzelnen Reihen R der LEDs 3 erstrecken.

Wie in Fig. 1 durch eingezeichnete Symmetrielinien erkennbar ist, besteht vorliegend in der Querrichtung ein seitlicher Versatz V1 einer Mitte 3a der LEDs 3 zu einer Mitte 6a ihrer Linsen 6 der Primäroptik 5.

Zudem haben die Mitten 6a der Linsen 6 als auch eine Mittelebene bzw. Mitte 3a der Reihe von LEDs 3 einen seitlichen Abstand bzw. Versatz V1+V2 in der Querrichtung zu einer optischen Zentralebene 9a einer das Licht dieser Reihe R bündelnden Zylinderlinse 9. V2 ist dabei der Versatz der Mitte 6a der Linsen 6 der Primäroptik zu der optischen Zentralebene 9a der Zylinderlinse. Dieser Versatz V1+V2 ist umso größer, je weiter die jeweilige Reihe R zu einer zentralen, mit der Linie der Zielfläche zusammenfallenden Mittelebene Z in der Querrichtung versetzt ist. Für eine Reihe R, die symmetrisch auf der Mittelebene Z angeordnet ist (siehe mittlere Reihe R in Fig. 1) liegt entsprechend kein Versatz vor.

Ein Vergleich der in Fig. 1 eingezeichneten Strahlengänge der linken, äußeren Reihe R und der mittleren, auf der Zentralebene Z angeordneten Reihe R von LEDs 3 verdeutlicht dies. Die Lichtstrahlen der randseitigen LEDs müssen in einem Winkel zu der Hauptabstrahlrichtung (Senkrechte auf die Modulfläche) gebündelt werden, um die Linie in der zielfläche zu treffen.

Durch den jeweiligen seitlichen Versatz V1, V2 wird die Bündelung eines möglichst großen Öffnungswinkels der äußeren LEDs 3 in diesen Strahlengang optimiert.

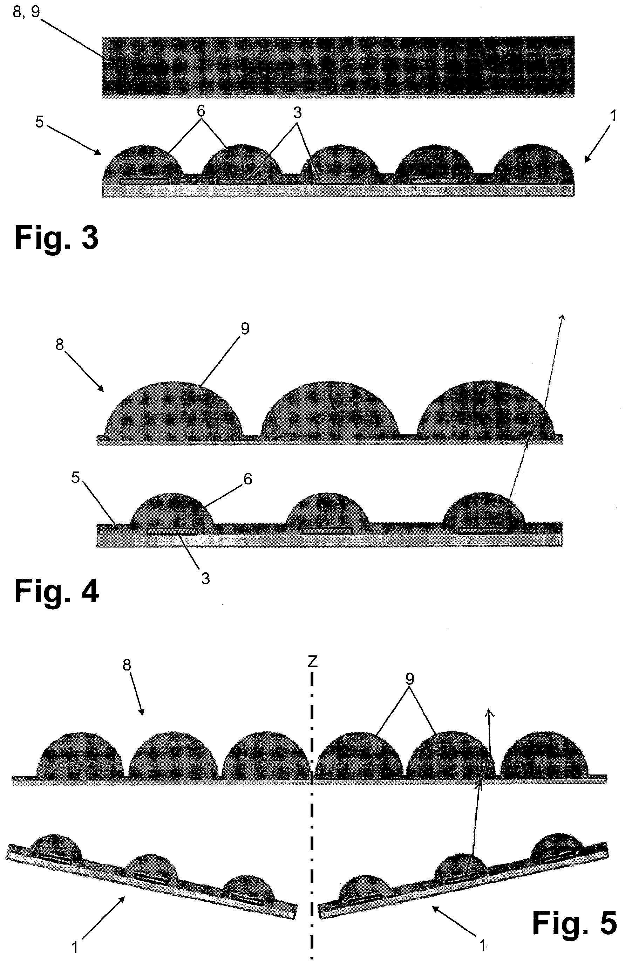

Bei der in Fig. 4 gezeigten Abwandlung liegt kein Versatz der LEDs 3 bzw. Linsen 6, 9 vor, so dass eine Bündelung der Reihen R jeweils in nebeneinander liegende Linien auf der Zielfläche erfolgt. Je nach Schärfe der Bündelung können diese Linien aber auch so stark überlappen, dass insgesamt eine relativ breite Linie entsteht, die auch eine gute Homogenität in der Querrichtung aufweisen kann.

Im Fall des in Fig. 5 dargestellten Ausführungsbeispiels der Erfindung ist die Sekundäroptik 8 wie im ersten Ausführungsbeispiel ausgebildet, wobei sämtliche Zylinderlinsen 9 in einer zu der Zielfläche parallelen Ebene liegen. Vor der Sekundäroptik sind in der Querrichtung zwei Module 1 mit Primäroptiken 5 nebeneinander angeordnet, die jeweils in entgegengesetzter Richtung um denselben Winkelbetrag gegenüber der Sekundäroptik geneigt sind. Eine Zentralebene Z verläuft hier symmetrisch zwischen zwei Zylinderlinsen 9 bzw. zwischen jeweils einer linken, inneren LED 3 des linken Moduls und einer rechten, inneren LED 3 des rechten Moduls. Die Verkippung der Module 1 bewirkt wie im ersten Beispiel eine Bündelung sämtlicher Reihen von LEDs R auf dieselbe Linie in der Zielfläche.

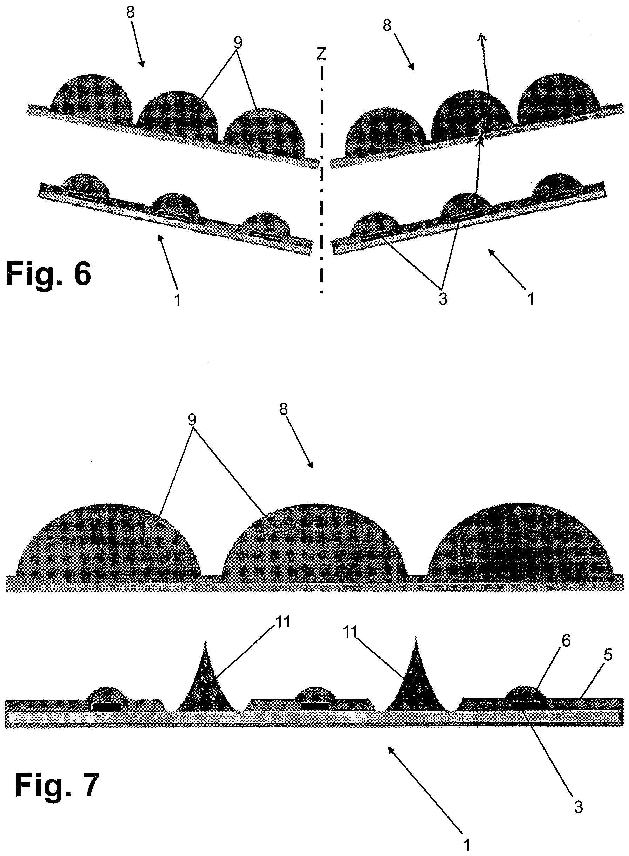

Bei dem Beispiel nach Fig. 6 ist im Unterschied zum Beispiel nach Fig. 5 vorgesehen, dass eine erste Sekundäroptik 8 links von der Zentralebene Z und eine zweite Sekundäroptik 8 rechts von der Zentralebene Z vorgesehen ist. Die Sekundäroptiken 8 sind hierbei ebenso wie die Primäroptiken 5 entgegen gesetzt geneigt angeordnet, um die Bündelung des Lichts der LED-Reihen R in dieselbe Linie bei zugleich möglichst großem Öffnungswinkel zu begünstigen. Vorliegend verlaufen die einander zugeordneten Primäroptiken 5 und Sekundäroptiken jeweils wieder parallel zueinander, wobei je nach Optimierung und Anforderungen auch hier eine geneigte Anordnung vorgesehen sein kann.

Bei dem Ausführungsbeispiel nach Fig. 7 sind im Unterschied zum ersten Ausführungsbeispiel zusätzliche Reflektoren 11 unmittelbar seitlich der LEDs 3 angeordnet. Hierdurch wird auch unter sehr großen Winkeln abgestrahltes Licht in den nutzbaren Strahlengang eingelenkt. Vorliegend erstrecken sich die Reflektoren 11 als prismatische Körper über die Längsrichtung des Moduls 1, wobei die reflektierenden Seitenwände konkav gebogen geformt sind.

Vorliegend werden die Primäroptiken nach einem in der WO 2012/031703 A1 im Prinzip beschriebenen Verfahren hergestellt, indem die COB-Module durch Silikon in einer offenen Giessform beschichtet werden. Die vorliegenden Sekundäroptiken werden nach einem analogen Verfahren hergestellt, bei dem an Stelle der COB-Module ein transparentes, flaches Substrat 10 mit UV-beständigem Silikon beschichtet wird, um die optisch wirksamen Strukturen 9 (Zylinderlinsen) zu erzeugen.

Eine Leuchte gemäß der vorstehend beschriebenen Ausführungsbeispiele wird zu Zwecken der UV-Trocknung von Lack bzw. Farbe in einer Druckmaschine, vorliegend Offset-Bodendruckmaschine, eingesetzt. Eine Erstreckung der Leuchte in der Längsrichtung beträgt typisch mehr als 1 Meter, im vorliegenden Beispiel 1,6 Meter, was der Bogenbreite des Druckerzeugnisses entspricht. Zur Realisierung solcher Längen werden typisch jeweils mehrere Module 1 und Sekundäroptiken 8 in der Längsrichtung hintereinander angeordnet.

Die vorstehend beschriebenen Komponenten der Leuchte sind in einem bezüglich des Bauraums optimierten Gehäuse (nicht dargestellt) aufgenommen.

Eine Bestrahlungsstärke auf der Zielfläche bezogen auf die Längsrichtung beträgt vorliegend rund 10 Watt pro cm. Dabei liegt der überwiegende Teil des Lichtes im Bereich einer Wellenlänge von weniger als 470 nm.

Um LED-Leuchten mit sehr hohen optischen Ausgangsleistungen herzustellen, werden 0,1-200 mm², typisch 1-2 mm² große LEDs im Chip-on-Board-Verfahren (COB) aufgebaut. Dabei werden mehrere LEDs, typisch 4-200 Chips, auf einem gemeinsamen Substrat mit einer Fläche in der Größenordnung von 5 bis 50 cm² zu einem Modul assembliert. Durch Aneinanderreihung von mit LEDs bestückten Modulen wird die gewünschte Lampengröße generiert.

## Patentansprüche

1. Leuchte, umfassend
zumindest ein Modul (1) mit einer Mehrzahl von über eine Modulfläche (2) verteilten LEDs (3),
wobei in einer Längsrichtung (L) des Moduls (1) mehrere LEDs in einer Reihe (R) angeordnet sind, und
wobei in einer zu der Längsrichtung (L) senkrechten Querrichtung (W) des Moduls (1) mehrere der Reihen (R) nebeneinander angeordnet sind, und wobei die LED-Leuchte eine Optik (5, 8) zur Bündelung des von den LEDs emittierten Lichts umfasst,
wobei die Optik (5, 8) zumindest eine erste, in der Längsrichtung erstreckte Zylinderlinse (9) umfasst, wobei das Licht zumindest einiger der LEDs (3) einer ersten der Reihen (3) mittels der ersten Zylinderlinse (9) in eine Linie auf einer Zielfläche gebündelt werden, wobei die Optik eine Primäroptik (5) zur Bündelung des abgestrahlten Lichts umfasst, und wobei die Optik eine Sekundäroptik (8) umfasst, die räumlich getrennt von dem Modul (1) in einem Strahlengang des Lichts angeordnet ist,
**dadurch gekennzeichnet, dass** die Primäroptik eine Mehrzahl von unmittelbar auf den LEDs angeordneten Linsen (6) umfasst, und die Zylinderlinse an der Sekundäroptik ausgebildet ist.

2. Leuchte nach Anspruch 1, **dadurch gekennzeichnet, dass** die Optik (5, 8) zumindest eine zweite, in der Längsrichtung erstreckte Zylinderlinse (9) umfasst, wobei das Licht zumindest einiger der LEDs (3) einer zweiten der Reihen (3) mittels der zweiten Zylinderlinse (9) in eine Linie auf einer Zielfläche gebündelt wird.

3. Leuchte nach Anspruch 2, **dadurch gekennzeichnet, dass** die erste Zylinderlinse (9) und die zweite Zylinderlinse (9) das Licht in dieselbe Linie auf der Zielfläche bündeln.

4. Leuchte nach einem der vorhergehenden Ansprüche, **dadurch gekennzeichnet, dass** die Primäroptik (5) Reflektoren (11) umfasst, die unmittelbar seitlich der LEDs (3) angeordnet sind.

5. Leuchte nach Anspruch 4, **dadurch gekennzeichnet, dass** die Primäroptik (5) als auf das Modul (1) aufgebrachte, transparente Polymerschicht ausgebildet ist, die zumindest mehrere LEDs (3) einstückig übergreift.

6. Leuchte nach einem der vorhergehenden Ansprüche, **dadurch gekennzeichnet, dass** die über den LEDs (3) angeordneten Linsen (6) mit einem seitlichen Versatz (V1) in der Querrichtung gegenüber einem Zentrum der LEDs (3a) positioniert sind.

7. Leuchte nach einem der vorhergehenden Ansprüche, **dadurch gekennzeichnet, dass** die Sekundäroptik (8) als transparente Polymerschicht auf einem transparenten Substrat (10) ausgebildet ist.

8. Leuchte nach einem der vorhergehenden Ansprüche, **dadurch gekennzeichnet, dass** die Sekundäroptik (8) mehrere in einer Ebene nebeneinander angeordnete Zylinderlinsen (9) umfasst.

9. Leuchte nach Anspruch 8, **dadurch gekennzeichnet, dass** die Ebene der Zylinderlinsen (9) relativ zu der Modulfläche (2) und/oder relativ zu der Zielfläche geneigt ist.

10. Leuchte nach einem der vorhergehenden Ansprüche, **dadurch gekennzeichnet, dass** eine Mittelebene (3a) der Reihe von LEDs (R) und eine hierzu parallele optische Zentralebene (9a) einer das Licht der Reihe bündelnden Zylinderlinse (9) einen Versatz (V2+V1) in der Querrichtung zueinander aufweisen.

11. Leuchte nach einem der vorhergehenden Ansprüche, **dadurch gekennzeichnet, dass** eine Packungsdichte der LEDs in der Längsrichtung (L) größer ist als in der Querrichtung (W).

12. Vorrichtung zum Trocknen einer Beschichtung, umfassend eine Leuchte nach einem der vorhergehenden Ansprüche.

13. Vorrichtung nach Anspruch 12, **dadurch gekennzeichnet, dass** ein flächiges Substrat mit der zu trocknenden Beschichtung und die Leuchte in einer Förderrichtung zueinander bewegbar sind, wobei die Leuchte in einer Querrichtung zumindest teilweise über eine Breite des Substrats erstreckt und in definiertem Abstand über dem Substrat angeordnet ist.

14. Verwendung einer Leuchte nach einem der Ansprüche 1 bis 11 zum Trocknen einer Beschichtung, insbesondere in einem Druckverfahren.

## Claims

1. Luminaire, comprising
at least one module (1) having a plurality of LEDs (3), which are distributed over a module surface (2),
wherein a plurality of LEDs are arranged in a row (R) in a longitudinal direction (L) of the module (1), and
wherein a plurality of the rows (R) are arranged one next to the other in a transverse direction (W) of the module (1) that is perpendicular to the longitudinal direction (L), and wherein the LED luminaire comprises an optical unit (5, 8) for bundling the light emitted by the LEDs,
wherein the optical unit (5, 8) comprises at least one first cylindrical lens (9), which extends in the longitudinal direction, wherein the light of at least some of the LEDs (3) of a first of the rows (3) is bundled into a line on a target surface using the first cylindrical lens (9),
wherein the optical unit comprises a primary optical unit (5) for bundling the output light,
wherein the optical unit comprises a secondary optical unit (8), which is arranged spatially separate from the module (1) in a beam path of the light,
**characterized in that** the primary optical unit comprises a plurality of lenses (6) which are arranged directly on the LEDs, and the cylindrical lens is formed at the secondary optical unit.

2. Luminaire according to Claim 1, **characterized in that** the optical unit (5, 8) comprises at least one second cylindrical lens (9), which extends in the longitudinal direction, wherein the light of at least some of the LEDs (3) of a second of the rows (3) is bundled into a line on a target surface using the second cylindrical lens (9).

3. Luminaire according to Claim 2, **characterized in that** the first cylindrical lens (9) and the second cylindrical lens (9) bundle the light into the same line on the target surface.

4. Luminaire according to one of the preceding claims, **characterized in that** the primary optical unit (5) comprises reflectors (11), which are arranged directly laterally of the LEDs (3).

5. Luminaire according to Claim 4, **characterized in that** the primary optical unit (5) is formed as a transparent polymer layer that is applied onto the module (1) and covers, in one piece, at least a plurality of LEDs (3).

6. Luminaire according to one of the preceding claims, **characterized in that** the lenses (6), which are arranged over the LEDs (3), are positioned with a lateral offset (V1) in the transverse direction with respect to a centre of the LEDs (3a).

7. Luminaire according to one of the preceding claims, **characterized in that** the secondary optical unit (8) is formed as a transparent polymer layer on a transparent substrate (10).

8. Luminaire according to one of the preceding claims, **characterized in that** the secondary optical unit (8) comprises a plurality of cylindrical lenses (9) which are arranged one next to the other in one plane.

9. Luminaire according to Claim 8, **characterized in that** the plane of the cylindrical lenses (9) is inclined relative to the module surface (2) and/or relative to the target surface.

10. Luminaire according to one of the preceding claims, **characterized in that** a central plane (3a) of the row of LEDs (R) and, parallel with respect thereto, an optical central plane (9a) of a cylindrical lens (9) bundling the light of the row have an offset (V2+V1) with respect to one another in the transverse direction.

11. Luminaire according to one of the preceding claims, **characterized in that** a packing density of the LEDs is greater in the longitudinal direction (L) than in the transverse direction (W).

12. Apparatus for drying a coating, comprising a luminaire according to one of the preceding claims.

13. Apparatus according to Claim 12, **characterized in that** an extensive substrate with the coating to be dried and the luminaire are movable with respect to one another in a transport direction, wherein the luminaire extends in a transverse direction at least partially over a width of the substrate and is arranged at a defined distance above the substrate.

14. Use of a luminaire according to one of Claims 1 to 11 for drying a coating, in particular in a printing method.

## Revendications

1. Lampe, comprenant
au moins un module (1) avec une pluralité de LED (3) réparties sur une surface de module (2),
plusieurs LED étant disposées en une rangée (R) dans une direction longitudinale (L) du module (1), et,
dans une direction transversale (W) du module (1) perpendiculaire à la direction longitudinale (L), plusieurs des rangées (R) étant juxtaposées, et la lampe à LED comprenant une optique (5, 8) destinée au regroupement en faisceau de la lumière émise par les LED,
l'optique (5, 8) comprenant au moins une première lentille cylindrique (9) s'étendant dans la direction longitudinale, la lumière d'au moins quelques-unes des LED (3) d'une première des rangées (3) étant, au moyen de la première lentille cylindrique (9), regroupée en faisceau en une ligne sur une surface cible,
l'optique comprenant une optique primaire (5) destinée au regroupement en faisceau de la lumière émise, et
l'optique comprenant une optique secondaire (8) qui est disposée de façon spatialement séparée du module (1) sur une trajectoire de faisceau de la lumière,
**caractérisée en ce que** l'optique primaire (5) comprend une pluralité de lentilles (6) disposées directement sur les LED, et la lentille cylindrique est constituée sur l'optique secondaire.

2. Lampe selon la revendication 1, **caractérisée en ce que** l'optique (5, 8) comprend au moins une deuxième lentille cylindrique (9) s'étendant dans la direction longitudinale, la lumière d'au moins quelques-unes des LED (3) d'une deuxième des rangés (3) étant, au moyen de la deuxième lentille cylindrique (9), regroupée en faisceau en une ligne sur une surface cible.

3. Lampe selon la revendication 2, **caractérisée en ce que** la première lentille cylindrique (9) et la deuxième lentille cylindrique (9) regroupent en faisceau la lumière en une même ligne sur la surface cible.

4. Lampe selon l'une des revendications précédentes, **caractérisée en ce que** l'optique primaire (5) comprend des réflecteurs (11) qui sont disposés directement sur le côté des LED (3).

5. Lampe selon la revendication 4, **caractérisée en ce que** l'optique primaire (5) est constituée en tant que couche de polymère transparente qui est appliquée sur le module (1) et qui recouvre d'un seul tenant les au moins plusieurs LED (3).

6. Lampe selon l'une des revendications précédentes, **caractérisée en ce que** les lentilles (6) disposées sur les LED (3) sont positionnées avec un décalage (V1) latéral dans la direction transversale par rapport à un centre des LED (3a).

7. Lampe selon l'une des revendications précédentes, **caractérisée en ce que** l'optique secondaire (8) est constituée en tant que couche de polymère transparente sur un substrat (10) transparent.

8. Lampe selon l'une des revendications précédentes, **caractérisée en ce que** l'optique secondaire (8) comprend plusieurs lentilles cylindriques (9) juxtaposées dans un plan.

9. Lampe selon la revendication 8, **caractérisée en ce que** le plan des lentilles cylindriques (9) est incliné vers la surface de module (2) et/ou relativement à la surface cible.

10. Lampe selon l'une des revendications précédentes, **caractérisée en ce qu'**un plan médian (3a) de la rangée de LED (R) et un plan central (9a) optique, qui lui est parallèle, d'une lentille cylindrique (9) regroupant en faisceau la lumière de la rangée présentent l'un par rapport à l'autre un décalage (V2+V1) dans la direction transversale.

11. Lampe selon l'une des revendications précédentes, **caractérisée en ce que** la densité de composants des LED est plus grande dans la direction longitudinale (L) que dans la direction transversale (W).

12. Dispositif destiné au séchage d'un revêtement, comprenant une lampe selon l'une des revendications précédentes.

13. Dispositif selon la revendication 12, **caractérisé en ce qu'**un substrat plan avec le revêtement à sécher et la lampe sont mobiles l'un par rapport à l'autre dans une direction de transport, la lampe s'étendant, dans une direction transversale, au moins partiellement sur une largeur du substrat et étant disposée à une distance définie au-dessus du substrat.

14. Utilisation d'une lampe selon l'une des revendications 1 à 11 pour le séchage d'un revêtement, en particulier dans un procédé d'impression.
